# FASCICULE DE BREVET EUROPEEN

(11) **EP 2 780 294 B1**
(45) Date de publication et mention de la délivrance du brevet: **27.03.2019**
(21) Numéro de dépôt: 12795542.5
(22) Date de dépôt: 14.11.2012
(51) Int. Cl.: C03C 17/34, C23C 16/40

(54) **COUCHE BARRIERE AUX METAUX ALCALINS A BASE DE SIOC ET PROCEDE DE FABRICATION**
SIOC-BARRIERESCHICHT FÜR ALKALIMETALLE UND VERFAHREN ZUR HERSTELLUNG
SIOC BARRIER LAYER TO ALKALI METALS AND PROCESS OF MAKING

(30) Priorité: 16.11.2011 FR 1160418
(43) Date de publication de la demande: 24.09.2014
(73) Titulaire: Saint-Gobain Glass France, 92400 Courbevoie (FR)
(72) Inventeur: THOUMAZET, Claire, F-75002 Paris (FR); MELCHER, Martin, 52134 Herzogenrath (DE); HUIGNARD, Arnaud, F-60200 Compigne (FR); LANTE, Raphael, 50134 Herzogenrath (DE)
(74) Mandataire: Saint-Gobain Recherche
(86) Numéro de dépôt international: PCT/FR2012/052622
(87) Numéro de publication internationale: WO 2013/072623

(56) Documents cités:
- EP-A1- 0 275 662
- EP-A1- 0 518 755
- WO-A1-2011/101572
- GB-A- 2 355 273
- US-A1- 2003 162 033
- RYAN JOSEPH ET AL: "Synthesis and characterization of inorganic silicon oxycarbide glass thin films by reactive rf-magnetron sputtering", JOURNAL OF VACUUM SCIENCE AND TECHNOLOGY: PART A, AVS /AIP, MELVILLE, NY., US, vol. 25, no. 1, 3 janvier 2007 (2007-01-03), pages 153-159, XP012102547, ISSN: 0734-2101, DOI: 10.1116/1.2404688

## Description

La présente invention concerne une couche mince transparente à base d'oxycarbure de silicium formant une barrière à la diffusion d'ions alcalins. L'invention concerne également un procédé de fabrication d'une telle couche sur un substrat en verre minéral.

Il est connu que la diffusion d'ions alcalins, en particulier d'ions sodium, depuis des substrats en verre (verre borosilicaté, verre sodo-calcique) vers et dans des couches minces fonctionnelles telles que des couches photocatalytiques à base de TiO₂, des couches d'oxydes conducteurs transparents (TCO) ou des couches organiques hydrophobes, détériore les propriétés intéressantes inhérentes à ces couches fonctionnelles.

Il est également connu d'interposer entre le substrat en verre minéral riche en ions alcalins et ladite couche fonctionnelle à protéger une couche mince d'un oxyde minéral en tant que barrière contre la diffusion des ions alcalins. On peut citer à titre d'exemples de tels oxydes la silice, l'alumine, la zircone, l'oxyde de zinc/étain, l'oxyde de titane et l'oxycarbure de silicium (SiOC). Les propriétés barrière aux ions alcalins de couches en oxycarbure de silicium sont mentionnées par exemple dans les demandes EP 1708812, EP 1686595, EP 275 662 et US 2003/162033.

A la connaissance de la Demanderesse il n'existe à l'heure actuelle aucune étude concernant l'influence de la teneur en carbone de couches de SiOC sur le pouvoir de blocage ou de capture des ions alcalins. Dans le cadre de ses études visant à optimiser des sous-couches en oxycarbure de silicium en vue de leur fonctionnalisation ultérieure par des agents hydrophobes, la Demanderesse a constaté que les couches d'oxycarbure de silicium les plus riches en carbone présentaient les meilleures propriétés de barrière aux ions alcalins et étaient également d'excellentes couches d'accrochage pour les agents fonctionnels hydrophobes.

L'augmentation de la teneur en carbone des couches minces en oxycarbure de silicium se traduisait toutefois par l'apparition indésirable d'une coloration jaune des vitrages. Une telle coloration est gênante d'un point de vue esthétique en particulier dans le domaine des vitrages automobiles et des vitrages pour l'habitat. Elle est encore plus difficilement acceptable dans le domaine des cellules photovoltaïques où elle réduit de façon significative le rendement énergétique en filtrant les composantes bleue et verte de la lumière visible.

La présente invention est basée sur la découverte qu'il était possible de réduire de façon significative la teinte jaune de couches minces en oxycarbure de silicium riches en carbone en déposant directement sur ces couches une couche d'oxycarbure de silicium significativement plus pauvre en carbone que la couche sous-jacente.

La présente invention concerne donc un substrat en verre contenant des ions de métaux alcalins, et qui est pourvu d'une première couche mince transparente d'oxycarbure de silicium riche en carbone et d'une deuxième couche mince transparente, déposée directement sur la première couche et qui est significativement moins riche en carbone que la première couche.

Comme il est toutefois souvent impossible de déterminer dans le produit final la limite entre la couche de SiOC riche en carbone et la couche pauvre en carbone ou exempte de carbone, ces deux couches sont définies dans la présente demande comme une couche unique avec une zone profonde riche en carbone (correspondant à la première couche mentionnée ci-dessus) et une zone superficielle pauvre en carbone (correspondant à la deuxième couche mentionnée ci-dessus).

La présente invention a par conséquent pour objet un vitrage comportant un substrat en verre transparent contenant des ions d'au moins un métal alcalin, et une couche transparente en oxycarbure de silicium (SiOₓC_{y}) d'une épaisseur totale E avec
- une zone profonde riche en carbone s'étendant d'une profondeur P₃ à une profondeur P₄, où le rapport atomique C/Si est supérieur ou égal à 0,5, et
- une zone superficielle pauvre en carbone s'étendant d'une profondeur P₁ à une profondeur P₂ où le rapport atomique C/Si est inférieur ou égal à 0,4,
avec P₁ < P₂ < P₃ < P₄, et (P₂-P₁) + (P₄-P₃) < E
la distance entre P₁ et P₂ représentant de 10 à 70 %, de préférence de 15 à 50 % et en particulier de 25 à 40%, de l'épaisseur totale E de la couche d'oxycarbure de silicium (0,1 ≤ (P₂-P₁)/E ≤ 0,7) et
la distance entre P₃ et P₄ représentant de 10 à 70 %, de préférence de 25 à 60 %, en particulier de 35 à 50 %, de l'épaisseur totale E de la couche d'oxycarbure de silicium (0,1 ≤ (P₄-P₃)/E ≤ 0,7).

La somme de la distance entre P₁ et P₂ et de la distance entre P₃ et P₄ est bien entendu toujours inférieure à l'épaisseur globale E de la couche d'oxycarbure de silicium car il existe entre P₂ et P₃ une zone où le rapport C/Si est intermédiaire entre 0,4 et 0,5, et au-delà de P₄ une zone où le rapport C/Si est inférieur à 0,5. Par ailleurs, la zone la plus superficielle, située à une profondeur inférieure à P₁, présente généralement un rapport C/Si extrêmement élevé dû à la présence de CO₂ provenant de l'atmosphère ou de polluants organiques adsorbés à la surface.

La couche d'oxycarbure de silicium du vitrage de la présente invention est une couche dense, non poreuse, ayant un indice de réfraction compris entre 1,45 et 1,9.

Son épaisseur totale E est de préférence comprise entre 10 et 200 nm, plus préférentiellement entre 20 et 100 nm, et en particulier entre 40 et 70 nm.

Les méthodes absolues permettant de déterminer la valeur de l'épaisseur totale de la couche d'oxycarbure de silicium sont la réflectométrie à rayons X et la microscopie électronique par transmission (MET).

Sur les figures en annexe, cette épaisseur totale de la couche SiOₓC_{y} est systématiquement indiquée par une flèche. Sur ces figures, et en particulier en vue de la détermination du rapport (P₂-P₁)/E et (P₄-P₃)/E, elle est déterminée non pas par une des méthodes absolues mentionnée ci-avant, mais par spectroscopie de masse à ionisation secondaire (SIMS, *secondary ion mass spectroscopy*) qui permet d'obtenir la variation de la teneur en silice (SiO₂) en fonction du temps d'analyse, et donc de la profondeur de l'échantillon analysé.

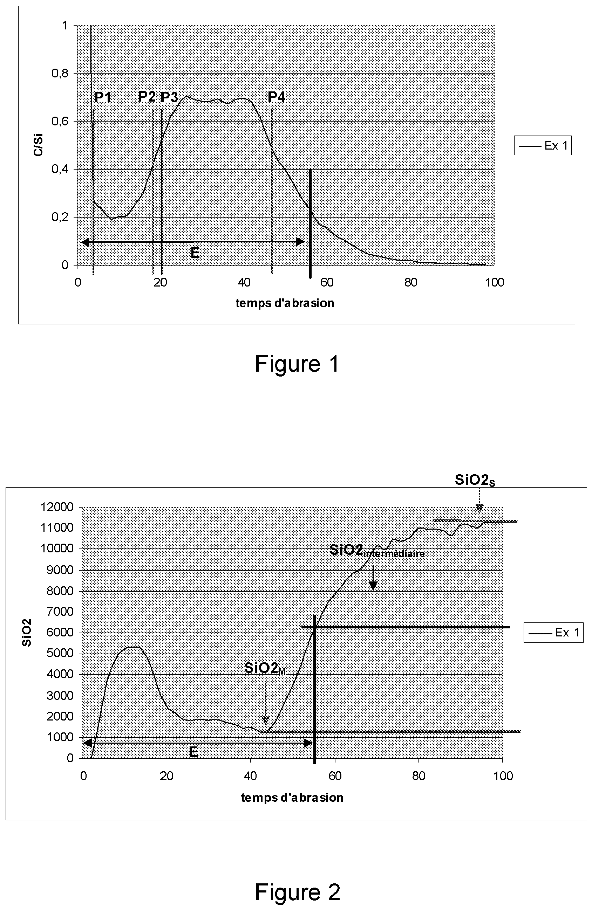

On définit dans la présente invention l'interface entre le substrat et la couche d'oxycarbure de silicium comme étant la profondeur où la concentration en silice est exactement intermédiaire entre celle du substrat en verre et celle au minimum local à proximité de l'interface. La détermination de cette profondeur correspondant à l'épaisseur totale E de la couche est illustrée à la figure 2 qui montre la variation de la teneur en silice (SiO₂) de l'échantillon de la figure 1. La teneur en silice du substrat en verre minéral est égale à SiO2_{S}, celle correspondant au minimum local à proximité de l'interface est égale à SiO2_{M}. L'interface entre le substrat en verre et la couche déposée par CVD est définie comme étant située à la profondeur où la teneur en silice (SiO2_{intermédiaire}) est à égale distance entre SiO2_{S} et SiO2_{M}. Cette profondeur E correspondant à SiO2_{intermédiaire} a été rapportée sur la figure 1.

La teneur en carbone de la couche d'oxycarbure de silicium est également déterminée par SIMS. Elle est exprimée dans la présente demande au moyen du rapport du nombre d'atomes de carbone au nombre d'atomes de silicium (rapport atomique C/Si).

La figure 1 montre, à titre d'exemple, le rapport C/Si en fonction du temps d'abrasion (pendant l'analyse SIMS) d'un échantillon selon l'invention. De manière connue, le temps d'abrasion (indiqué en abscisse) est proportionnel à la profondeur analysée, le facteur de proportionnalité dépendant des conditions expérimentales et de la nature et des propriétés de l'échantillon. On observe sur cette figure que le rapport C/Si est très élevée en surface, en raison d'éventuels polluants carbonés et/ou de CO₂ adsorbé provenant de l'atmosphère. Dans les couches peu profondes, entre P₁ et P₂, il est relativement faible (de l'ordre de 0,2), augmente ensuite avec la profondeur pour dépasser la valeur de 0,4 à une profondeur P₂, puis la valeur de 0,5 à partir d'une profondeur P₃. Il reste supérieur à cette valeur jusqu'à une profondeur P₄ et tend ensuite vers zéro lorsqu'on arrive dans le substrat en verre.

Comme déjà expliqué en introduction, la présente invention est basée sur la découverte que la teinte jaune de couches minces en oxycarbure de silicium riches en carbone peut être atténuée, voire supprimée, par le dépôt d'une mince couche d'oxycarbure de silicium pauvre en carbone.

Dans la présente demande cette teinte jaune est quantifiée de façon connue à l'aide du système colorimétrique CIE L*a*b* (ci-après CIELab) à partir de mesures faites sur le vitrage, après dépôt des couches. Le système CIELab définit un espace colorimétrique en forme de sphère avec un axe L* caractérisant la clarté, un axe a* rouge/vert et un axe b* bleu/jaune. Une valeur a* supérieure à 0 correspond à des teintes avec une composante rouge, une valeur a* négative à des teintes avec une composante verte, une valeur b* positive à des teintes avec une composante jaune et une valeur b* négative à des teintes avec une composante bleue.

De manière générale, on recherchera à obtenir des couches de teinte grise ou incolore, présentant des valeurs a* et b* faibles, c'est-à-dire proches de zéro.

Les vitrages de la présente invention ont de préférence une valeur b* (CIELab, illuminant D65) comprise entre -2 et +3, en particulier entre -1,5 et +2,0 ; et une valeur a* (CIELab, illuminant D65) comprise entre -2 et +2, en particulier entre -1,5 et +1,5. Ces valeurs s'entendent pour des vitrages avec des couches déposées sur un substrat transparent incolore en verre *float* clair commercialisé par la société Saint-Gobain Glass France sous la dénomination commerciale SGG Planilux®.

La présente invention a également pour objet un procédé de fabrication des vitrages décrits ci-dessus.

Ce procédé comprend essentiellement les deux étapes successives suivantes :
(a) une première étape de dépôt chimique en phase vapeur (CVD) d'une couche d'oxycarbure de silicium riche en carbone, sur au moins une partie de la surface d'un substrat en verre minéral par mise en contact de ladite surface, avec un flux de gaz contenant de l'éthylène (C₂H₄), du silane (SiH₄), du dioxyde de carbone (CO₂) et de l'azote (N₂), à une température comprise entre 600 °C et 680 °C, le rapport volumique d'éthylène/silane (C₂H₄/SiH₄) au cours de l'étape (a) étant inférieur ou égal à 3,3,
(b) une deuxième étape de dépôt chimique en phase vapeur (CVD) d'une couche d'oxycarbure de silicium pauvre en carbone sur la couche riche en carbone obtenue à l'étape (a), avec un flux de gaz contenant de l'éthylène (C₂H₄), du silane (SiH₄), du dioxyde de carbone (CO₂) et de l'azote (N₂), à une température comprise entre 600 °C et 680 °C, le rapport volumique d'éthylène/silane (C₂H₄/SiH₄) au cours de l'étape (b1) étant supérieur à 3,4.

La première étape (étape (a)) est de préférence mise en oeuvre sur du verre *float* à l'intérieur du four sur bain d'étain ou immédiatement après la sortie du four. Un mode de réalisation particulièrement avantageux consiste à effectuer le dépôt par CVD à l'intérieur du four, où il est relativement facile de créer une atmosphère confinée indispensable à un contrôle satisfaisant de la composition chimique du mélange réactif et de la couche déposée.

Les températures de dépôt indiquées ci-dessus sont les températures du bain d'étain mesurées à proximité immédiate (moins de 20 cm) de la buse par laquelle arrivent les réactifs gazeux.

Lorsque les deux couches (étape (a) et (b) sont déposées par CVD, deux buses sont disposées parallèlement l'une à l'autre, à une distance généralement comprise entre 2 et 5 m, celle en amont dans la direction de défilement du ruban formant la couche/zone la plus profonde et celle en aval formant la couche/zone la moins profonde.

Chacune des buses couvre de préférence toute la largeur du ruban de verre.

Il est important de noter que, bien que le procédé comporte deux étapes de formation d'une couche d'oxycarbure de silicium, ces « couches » sont impossibles à distinguer l'une de l'autre dans le produit final où elles correspondent à des zones riches et pauvres en carbone de l'unique couche d'oxycarbure de silicium.

Le dépôt de couches minces d'oxycarbure de silicium par CVD est connu et l'homme du métier saura ajuster les débits des gaz réactifs en fonction de la vitesse de défilement du verre, des températures du four, et de l'épaisseur des couches qu'il souhaite obtenir. Dans la présente invention, les conditions expérimentales de l'étape (a) et éventuellement (b1) sont ajustées de préférence de manière à ce que l'épaisseur de la couche de SiOₓC_{y} déposée soit, après l'étape (b1) comprise entre 10 et 200 nm, en particulier entre 20 et 100 nm et de manière particulièrement préférée entre 40 et 70 nm. Ces fourchettes d'épaisseur totale sont également préférées lorsqu'on dépose au dessous de la zone SiOₓC_{y} riche en carbone une couche de silice par une méthode autre que le CVD.

Le rapport volumique éthylène/silane (C₂H₄/SiH₄) au cours de l'étape (a) est de préférence compris entre 1 et 3,3 en particulier entre 1,5 et 3,3. Le rapport du gaz oxydant (CO₂) au silane (SiH₄) est généralement compris entre 1 et 50, de préférence entre 1,5 et 10 et en particulier entre 2 et 6.

Pour le dépôt de la couche d'oxycarbure de silicium pauvre en carbone (étape (b)) le rapport volumique éthylène/silane (C₂H₄/SiH₄) est de préférence compris entre 3,5 et 6, en particulier entre 3,7 et 5,5.

Le procédé de fabrication des vitrages de la présente invention, comporte, de préférence, en outre après l'étape (b) une troisième étape (étape (c)) de recuit et/ou mise en forme du substrat portant la couche d'oxycarbure de silicium. Au cours de cette étape (c) le substrat est porté à une température comprise entre 580 °C et 700 °C, de préférence entre 600 °C et 680 °C.

### Exemples

On prépare un vitrage selon l'invention par CVD (C₂H₂, SiH₄, CO₂, N₂) avec deux buses CVD parallèles d'une largeur de 3,3 m chacune, sur un substrat en verre *float* clair (Planilux®) respectivement à une température de 648 °C et 638 °C (température du bain d'étain à proximité immédiate de la buse) ; la largeur du ruban est de 3,6 m, son épaisseur de 2,5 mm et sa vitesse de défilement de 15 m/min. Les deux buses sont à l'intérieur du four de fabrication du verre, à une distance de 3 m l'une de l'autre.

La première buse en amont délivre le mélange de gaz réactifs suivant :
SiH₄: 14 nL/min, CO₂ : 30 nL/min, C₂H₄ : 39 nL/min (dans diluant N₂) (rapport volumique C₂H₄/SiH₄ = 2,79)

La deuxième buse, en aval de la première, délivre le mélange de gaz réactifs suivant :
SiH₄ : 14 nL/min, CO₂ : 30 nL/min, C₂H₄ : 52 nL/min (dans diluant N₂) (rapport volumique C₂H₄/SiH₄ = 3,71)

On fabrique dans les mêmes conditions expérimentales un vitrage comparatif. Cet exemple comparatif se distingue simplement de l'exemple selon l'invention par le fait que la deuxième buse délivre un mélange de gaz identique à celui de la deuxième buse, à savoir le mélange suivant :
SiH₄: 14 nL/min, CO₂ : 30 nL/min, C₂H₄ : 39 nL/min (dans diluant N₂) (rapport volumique C₂H₄/SiH₄ = 2,79).

L'ensemble des vitrages sont soumis à une étape de recuit à une température de 640 °C pendant 8 minutes.

La figure 1 montre le spectre SIMS du vitrage selon l'invention où le rapport (P₂-P₁)/E est égal à environ 29 % et le rapport (P₄-P₃)/E égal à environ 46 %.

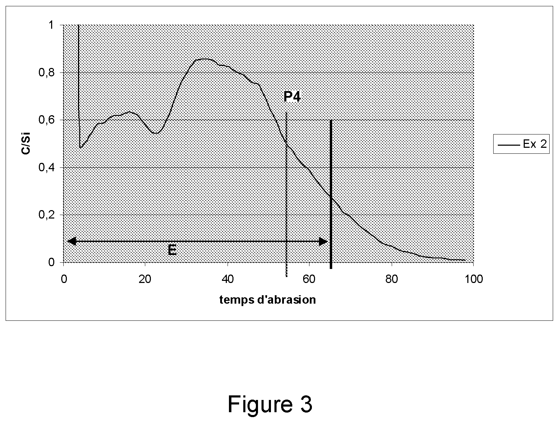

La figure 3 montre le spectre SIMS de l'exemple comparatif. La couche d'oxycarbure de silicium de cet échantillon présente une teneur élevée en carbone (C/Si > 0,4) à la fois dans la zone superficielle et dans la zone plus profonde. Il est impossible de déterminer les valeurs de P1, P2 et P3.

Le tableau 1 présente les valeurs des paramètres a* et b* (CIELab) des vitrages obtenus selon l'exemple et l'exemple comparatif.

On peut constater que l'échantillon de l'exemple comparatif dépourvue d'une couche superficielle exempte de carbone ou pauvre en carbone présente une teinte jaune (b* = 3,52) assez importante. Cette valeur est significativement réduite pour l'exemple selon l'invention (b* = 1,39) par la présence de la couche pauvre en carbone de l'exemple selon l'invention.

**Tableau 1**

| | Exemple selon l'invention | Exemple comparatif |
|---|---|---|
| Transmission lumineuse | 82,08 % | 78,57 % |
| a* | -0,95 | -1,09 |
| b* | **1,39** | **3,52** |
| Epaisseur totale déterminée par MET | 60,8 nm | 54 nm |

## Revendications

1. Vitrage comportant un substrat en verre transparent contenant des ions d'au moins un métal alcalin, et une couche transparente en oxycarbure de silicium (SiOₓC_{y}) d'une épaisseur totale E avec
(a) une zone profonde riche en carbone, s'étendant d'une profondeur P₃ à une profondeur P₄, où le rapport atomique C/Si est supérieur ou égal à 0,5, et
(b) une zone superficielle pauvre en carbone, s'étendant d'une profondeur P₁ à une profondeur P₂, où le rapport atomique C/Si est inférieur ou égal à 0,4,
avec P₁ < P₂ < P₃ < P₄, et (P₂-P₁) + (P₄-P₃) < E
la distance entre P₁ et P₂ représentant de 10 à 70 % de l'épaisseur totale E de la couche d'oxycarbure de silicium et
la distance entre P3 et P4 représentant de 10 à 70 % de l'épaisseur totale E de la couche d'oxycarbure de silicium.

2. Vitrage selon la revendication 1, **caractérisé par le fait que** l'épaisseur totale E de la couche de SiOₓC est comprise entre 10 et 200 nm, de préférence entre 20 et 100 nm, en particulier entre 40 et 70 nm.

3. Vitrage selon la revendication 1 ou 2, **caractérisé par le fait que** la couche transparente en oxycarbure de silicium est une couche non poreuse ayant un indice de réfraction compris entre 1,45 et 1,9.

4. Vitrage selon l'une quelconque des revendications précédentes, **caractérisé par le fait qu'**il présente une valeur b* (CIELab) comprise entre - 2 et +3, en particulier entre -1,5 et +2,0.

5. Procédé de fabrication d'un vitrage selon l'une quelconque des revendications précédentes, **caractérisé par le fait qu'**il comprend :
(a) une première étape de dépôt chimique en phase vapeur (CVD) d'une couche d'oxycarbure de silicium riche en carbone, sur au moins une partie de la surface d'un substrat en verre minéral, par mise en contact de ladite surface avec un flux de gaz contenant de l'éthylène (C₂H₄), du silane (SiH₄), du dioxyde de carbone (CO₂) et de l'azote (N₂), à une température comprise entre 600 °C et 680 °C, le rapport volumique d'éthylène/silane (C₂H₄/SiH₄) au cours de l'étape (a) étant inférieur ou égal à 3,3,
(b) une deuxième étape de CVD d'une couche d'oxycarbure de silicium pauvre en carbone sur la couche riche en carbone obtenue à l'étape (a), avec un flux de gaz contenant de l'éthylène (C₂H₄), du silane (SiH₄), du dioxyde de carbone (CO₂) et de l'azote (N₂), à une température comprise entre 600 °C et 680 °C, le rapport volumique d'éthylène/silane (C₂H₄/SiH₄) au cours de l'étape (b) étant supérieur à 3,4.

6. Procédé selon la revendication 5, **caractérisé par le fait qu'**il comprend en outre une étape de recuit et/ou de mise en forme à une température comprise entre 580 °C et 700 °C, de préférence entre 600 °C et 680 °C.

## Patentansprüche

1. Verglasung, umfassend ein transparentes Glassubstrat, das Ionen von mindestens einem Alkalimetall enthält, und eine transparente Schicht aus Siliziumoxycarbid (SiOₓC_{y}) mit einer Gesamtdicke E, **gekennzeichnet durch**
(a) eine kohlenstoffreiche tiefe Zone, die sich von einer Tiefe P₃ bis zu einer Tiefe P₄ erstreckt, in der das C/Si-Atomverhältnis größer oder gleich 0,5 ist, und
(b) eine kohlenstoffarme oberflächliche Zone, die sich von einer Tiefe P₁ bis zu einer Tiefe P₂ erstreckt, in der das C/Si-Atomverhältnis kleiner oder gleich 0,4 ist,
mit P₁ < P₂ < P₃ < P₄ und (P₂-P₁) + (P₄-P₃) < E,
wobei der Abstand zwischen P₁ und P₂ 10 bis 70 % der Gesamtdicke E der Siliziumoxycarbidschicht ausmacht und
der Abstand zwischen P3 und P4 10 bis 70 % der Gesamtdicke E der Siliziumoxycarbidschicht ausmacht.

2. Verglasung nach Anspruch 1, **dadurch gekennzeichnet, dass** die Gesamtdicke E der SiOₓC-Schicht zwischen 10 und 200 nm, vorzugsweise zwischen 20 und 100 nm, insbesondere zwischen 40 und 70 nm liegt.

3. Verglasung nach Anspruch 1 oder 2, **dadurch gekennzeichnet, dass** die transparente Siliziumoxycarbidschicht eine nichtporöse Schicht mit einem Brechungsindex zwischen 1,45 und 1,9 ist.

4. Verglasung nach einem der vorhergehenden Ansprüche, **dadurch gekennzeichnet, dass** sie einen Wert b* (CIELab) zwischen -2 und +3, insbesondere zwischen -1,5 und +2,0 aufweist.

5. Verfahren zum Herstellen einer Verglasung nach einem der vorhergehenden Ansprüche, **dadurch gekennzeichnet, dass** es umfasst:
(a) einen ersten Schritt des chemisches Abscheidens aus der Dampfphase (CVD) einer kohlenstoffreichen Siliziumoxycarbidschicht auf mindestens einem Teil der Oberfläche eines Mineralglassubstrats durch Kontaktieren der Oberfläche mit einem Gasstrom enthaltend Ethylen (C₂H₄), Silan (SiH₄), Kohlendioxid (CO₂) und Stickstoff (N₂) bei einer Temperatur zwischen 600 °C und 680 °C, wobei das Volumenverhältnis von Ethylen zu Silan (C₂H₄/SiH₄) in Schritt (a) unter oder gleich 3,3 ist,
(b) einen zweiten CVD-Schritt zum Abscheiden einer kohlenstoffarmen Siliziumoxycarbidschicht auf der in Schritt (a) erhaltenen kohlenstoffreichen Schicht mit einem Gasstrom, der Ethylen (C₂H₄), Silan (SiH₄), Kohlendioxid (CO₂) und Stickstoff (N₂) enthält, bei einer Temperatur zwischen 600 °C und 680 °C, wobei das Volumenverhältnis von Ethylen zu Silan (C₂H₄/SiH₄) in Schritt (b) größer als 3,4 ist.

6. Verfahren nach Anspruch 5, **dadurch gekennzeichnet, dass** es ferner einen Glüh- und/oder Formschritt bei einer Temperatur zwischen 580 °C und 700 °C, vorzugsweise zwischen 600 °C und 680 °C umfasst.

## Claims

1. A glazing comprising a transparent glass substrate containing ions of at least one alkali metal and a transparent layer made of silicon oxycarbide (SiOₓC_{y}) having a total thickness E **characterized by**
(a) a carbon-rich deep zone, extending from a depth P₃ to a depth P₄, where the C/Si atomic ratio is greater than or equal to 0.5, and
(b) a carbon-poor surface zone, extending from a depth P₁ to a depth P₂, where the C/Si atomic ratio is less than or equal to 0.4,
with P₁ < P₂ < P₃ < P₄ and (P₂-P_{d} + (P₄-P₃) < E the distance between P₁ and P₂ representing from 10% to 70% of the total thickness E of the silicon oxycarbide layer and
the distance between P₃ and P₄ representing from 10% to 70% of the total thickness E of the silicon oxycarbide layer.

2. The glazing as claimed in claim 1, **characterized in that** the total thickness E of the SiOₓC layer is between 10 and 200 nm, preferably between 20 and 100 nm, in particular between 40 and 70 nm.

3. The glazing as claimed in claim 1 or 2, **characterized in that** the transparent silicon oxycarbide layer is a non-porous layer having a refractive index between 1.45 and 1.9.

4. The glazing as claimed in any one of the preceding claims, **characterized in that** it has a b* (CIELab) value between -2 and +3, in particular between -1.5 and +2.0.

5. A process for manufacturing a glazing as claimed in any one of the preceding claims, **characterized in that** it comprises:
(a) a first step of chemical vapor deposition (CVD) of a carbon-rich silicon oxycarbide layer onto at least one part of the surface of a mineral glass substrate, by bringing said surface into contact with a gas flow containing ethylene (C₂H₄), silane (SiH₄), carbon dioxide (CO₂) and nitrogen (N₂), at a temperature between 600°C and 680°C, the ethylene/silane (C₂H₄/SiH₄) volume ratio during step (a) being less than or equal to 3.3,
(b) a second step of CVD of a carbon-poor silicon oxycarbide layer onto the carbon-rich layer obtained in step (a), with a gas flow containing ethylene (C₂H₄), silane (SiH₄), carbon dioxide (CO₂) and nitrogen (N₂), at a temperature between 600°C and 680°C, the ethylene/silane (C₂H₄/SiH₄) volume ratio during step (b) being less than or equal to 3.4.

6. The process as claimed in claim 5, **characterized in that** it also comprises a step of annealing and/or forming at a temperature between 580°C and 700°C, preferably between 600°C and 680°C.
